(19) Europäisches Patentamt
European Patent Office
Office européen des brevets

(11) **EP 4 101 812 A1**

(12) **EUROPEAN PATENT APPLICATION**
published in accordance with Art. 153(4) EPC

(43) Date of publication:
**14.12.2022 Bulletin 2022/50**

(21) Application number: **21781629.7**

(22) Date of filing: **26.03.2021**

(51) International Patent Classification (IPC):
*C01B 21/064* $^{(2006.01)}$    *H01L 23/373* $^{(2006.01)}$
*C04B 38/00* $^{(2006.01)}$    *C04B 41/83* $^{(2006.01)}$
*C04B 35/583* $^{(2006.01)}$    *H05K 7/20* $^{(2006.01)}$

(52) Cooperative Patent Classification (CPC):
**C01B 21/064; C04B 35/583; C04B 38/00;
C04B 41/83; H01L 23/373; H05K 7/20**

(86) International application number:
**PCT/JP2021/013054**

(87) International publication number:
**WO 2021/200725 (07.10.2021 Gazette 2021/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.03.2020 JP 2020064844
29.09.2020 JP 2020163439**

(71) Applicant: **Denka Company Limited
Tokyo 103-8338 (JP)**

(72) Inventors:
• **IKARASHI Koki
Tokyo 103-8338 (JP)**
• **SUZUKI Nobuya
Tokyo 103-8338 (JP)**
• **NISHIMURA Koji
Tokyo 103-8338 (JP)**
• **TAKEDA Makoto
Tokyo 103-8338 (JP)**
• **KOBASHI Seiji
Tokyo 103-8338 (JP)**

(74) Representative: **Hoffmann Eitle
Patent- und Rechtsanwälte PartmbB
Arabellastraße 30
81925 München (DE)**

(54) **BORON NITRIDE SINTERED BODY, METHOD FOR MANUFACTURING SAME, LAMINATE, AND METHOD FOR MANUFACTURING SAME**

(57) Provided is a boron nitride sintered body having a porous structure, the boron nitride sintered body including a lump particle formed by aggregation of primary particles of boron nitride and having a particle diameter of 15 µm or more. Provided is a method for manufacturing a boron nitride sintered body, the method including: a nitriding step of firing a raw material powder containing boron carbide in an atmosphere containing nitrogen to obtain a fired product including lump particles each having a core part with primary particles of boron carbonitride aggregated and a shell part surrounding the core part; and a firing step of molding and heating a blend containing the fired product including lump particles and a sintering aid to obtain the boron nitride sintered body having a porous structure and including lump particles of boron nitride.

EP 4 101 812 A1

*Fig.1*

## Description

## Technical Field

The present disclosure relates to a boron nitride sintered body, a method for manufacturing the same, a composite body, and a method for manufacturing the same.

## Background Art

In components such as a power device, a transistor, a thyristor, and a CPU, efficient dissipation of heat generated during use thereof is required. From such a request, conventionally, a thermal conductivity of an insulating layer of a printed-wiring board onto which an electronic component is to be mounted has been improved, or an electronic component or a printed-wiring board has been mounted onto a heat sink via thermal interface materials having electrical insulation properties. As the insulating layer and the thermal interface material as described above, ceramic materials have been used.

Boron nitride that is one kind of ceramic materials is excellent in lubricating properties, thermal conducting properties, and insulation properties. Hence it has been studied to use boron nitride and a material, which is obtained by forming boron nitride and another material into a composite, as the insulating layer and the thermal interface material as described above. For example, Patent Literature 1 has proposed a technique of forming a boron nitride molded body and a resin into a composite and adjusting an orientation degree and a graphitization index of boron nitride in predetermined ranges to decrease the anisotropy of the thermal conductivity while attaining an excellent thermal conductivity.

## Citation List

## Patent Literature

Patent Literature 1: Japanese Unexamined Patent Publication No. 2014-162697

## Summary of Invention

## Technical Problem

With an increase in integration density of a circuit in a device such as a semiconductor device in recent years, it has been required that various members constituting the device are mounted with high positional accuracy and have high reliability. In this regard, the present disclosure provides a boron nitride sintered body with which a composite body excellent in adhesiveness with other members can be formed and a method for manufacturing the same. Furthermore, the present disclosure provides a composite body excellent in adhesiveness with other members and a method for manufacturing the same.

## Solution to Problem

According to an aspect of the present disclosure, there is provided a boron nitride sintered body having a porous structure, the boron nitride sintered body including a lump particle formed by aggregation of primary particles of boron nitride and having a particle diameter of 15 μm or more. Since such a boron nitride sintered body has a porous structure, a composite body can be manufactured by impregnating the boron nitride sintered body with a resin composition. Further, since the lump particle having a predetermined particle diameter or more is formed by aggregation of primary particles, it is difficult to impede the flow of a resin inside the boron nitride sintered body by the primary particles. The flow of the resin can be smoothly performed accordingly. Thus, when a composite body including the boron nitride sintered body and the resin is formed, the flow-out amount of the resin when the composite body is connected to other members increases, so that adhesiveness can be improved.

In an image obtained by magnifying a cross-section of the boron nitride sintered body observed with a scanning electron microscope at 500 times, an average number of the lump particles having the particle diameter of 15 μm or more included in a rectangular field of view of 180 μm × 255 μm may be 5 or more. Thereby, the flow of the resin inside the boron nitride sintered body is further smoothly performed, so that the flow-out amount of the resin from the composite body when the composite body is connected to other members can be further increased. The adhesiveness of the composite body can therefore be further improved.

An average value of aspect ratios of the lump particles may be 1 to 6. Thereby, the anisotropy and drift of the flow of the resin are decreased, so that the flow-out amount of the resin from the composite body can be further increased.

Therefore, the adhesiveness of the composite body can be further improved.

The lump particle may have a core part with primary particles of boron nitride aggregated, and a shell part surrounding the core part. Thereby, it is difficult to impede the flow of the resin near the surface of the lump particle, so that the fluidity of the resin can be further improved.

An orientation index of the boron nitride sintered body may be 10 or more. Thereby, the anisotropy when the resin composition is impregnated is decreased, so that the resin can be filled inside the boron nitride sintered body with high uniformity. Thereby, the electrical insulation properties of the composite body can be further improved.

The boron nitride sintered body may include a plurality of the lump particles, and at least one of the plurality of lump particles may have a through-hole. By the lump particle having such a through-hole, the circulation of the resin is further smoothly performed, so that the flow-out amount of the resin from the composite body when the composite body is connected to other members can be much further increased. The adhesiveness of the composite body can therefore be much further improved.

According to an aspect of the present disclosure, there is provided a method for manufacturing a boron nitride sintered body, the method including: a nitriding step of firing a raw material powder containing boron carbide in an atmosphere containing nitrogen to obtain a fired product including lump particles each having a core part with primary particles of boron carbonitride aggregated and a shell part surrounding the core part; and a firing step of molding and heating a blend containing the fired product including lump particles and a sintering aid to obtain a boron nitride sintered body having a porous structure and including lump particles of boron nitride.

In the above-described manufacturing method, the firing step is performed using the fired product including lump particles each having a core part and a shell part. Hence, in the firing step, the boron nitride sintered body including sufficiently large lump particles of boron nitride can be obtained. Since such a boron nitride sintered body has a porous structure, a composite body can be manufactured by impregnating the boron nitride sintered body with a resin composition. Further, since the boron nitride sintered body includes sufficiently large lump particles, it is difficult to impede the flow of a resin inside the boron nitride sintered body. Therefore, the flow of the resin can be smoothly performed. Thus, when a composite body including the boron nitride sintered body and the resin is formed, the flow-out amount of the resin when the composite body is connected to other members increases, so that adhesiveness can be improved.

The lump particle may be formed by aggregation of primary particles of boron nitride and may have a particle diameter of 15 $\mu$m or more. Thereby, it is difficult to impede the flow of the resin inside the boron nitride sintered body by the primary particles, so that the flow-out amount of the resin when the composite body is connected to other members can be further increased.

A specific surface area of at least one of the fired product and the blend used in the firing step may be less than 12 $m^2/g$. Thereby, sufficiently large lump particles can be formed in the boron nitride sintered body. Thereby, the flow of the resin inside the boron nitride sintered body can be further smoothly performed.

According to an aspect of the present disclosure, there is provided a composite body including any of the above-described boron nitride sintered bodies and a resin filled in pores of the boron nitride sintered body. Since such a composite body includes the above-described boron nitride sintered body, the flow of the resin is smoothly performed, so that the flow-out amount of the resin can be sufficiently increased. Thereby, adhesiveness with other members can be improved.

According to an aspect of the present disclosure, there is provided a method for manufacturing a composite body, the method including an impregnating step of impregnating pores of a boron nitride sintered body obtained by any of the above-described manufacturing methods with a resin composition, the composite body having the boron nitride sintered body and a resin filled in at least some of the pores of the boron nitride sintered body. In this manufacturing method, since the above-described boron nitride sintered body is used, the flow of the resin in the composite body thus obtained is smoothly performed, so that the flow-out amount of the resin can be sufficiently increased. Such a composite body can improve adhesiveness with other members.

The above-described manufacturing method may include a semi-curing step of semi-curing the resin composition impregnated in the pores of the boron nitride sintered body. Thereby, the amount of the resin filled inside the boron nitride sintered body can be maintained while the flow-out amount of the resin when the composite body is pressure-bonded and connected to other members is sufficiently secured.

## Advantageous Effects of Invention

It is possible to provide a boron nitride sintered body with which a composite body excellent in adhesiveness with other members can be formed and a method for manufacturing the same. Furthermore, it is possible to provide a composite body excellent in adhesiveness with other members and a method for manufacturing the same.

**Brief Description of Drawings**

FIG. 1 is a view schematically illustrating a cross-section of a lump particle of boron nitride included in a boron nitride sintered body of an embodiment.

FIG. 2 is an SEM (scanning electron microscope) photograph showing an example of a cross-section of a boron nitride sintered body of an embodiment.

FIG. 3 is an SEM photograph of an example of lump particles of boron carbonitride obtained in a nitriding step.

FIG. 4 is an SEM photograph showing an example of a cross-section of a molded body.

FIG. 5 is an SEM photograph of a cross-section of a lump particle included in a fired product.

FIG. 6 is an SEM photograph of a boron carbonitride powder obtained by pulverizing a fired product in Comparative Example 1.

FIG. 7 is an SEM photograph showing a cross-section of a boron nitride sintered body of Comparative Example 1.

**Description of Embodiments**

Hereinafter, embodiments of the present disclosure will be described with reference to the drawings as necessary. However, the following embodiments are examples for describing the present disclosure and are not intended to limit the present disclosure to the following contents.

A boron nitride sintered body according to an embodiment has a porous structure and includes a lump particle of boron nitride formed by aggregation of primary particles of boron nitride. Since the boron nitride sintered body has a porous structure, a composite body can be manufactured by impregnating the boron nitride sintered body with a resin composition. The particle diameter of the lump particle is 15 $\mu$m or more. Thereby, when a composite body including the boron nitride sintered body and a resin is formed, the flow-out amount of the resin when the composite body is connected to other members increases, so that adhesiveness can be improved. From the viewpoint of further smoothly performing the flow of the resin inside the boron nitride sintered body, the particle diameter of the lump particle may be 20 $\mu$m or more or may be 25 $\mu$m or more.

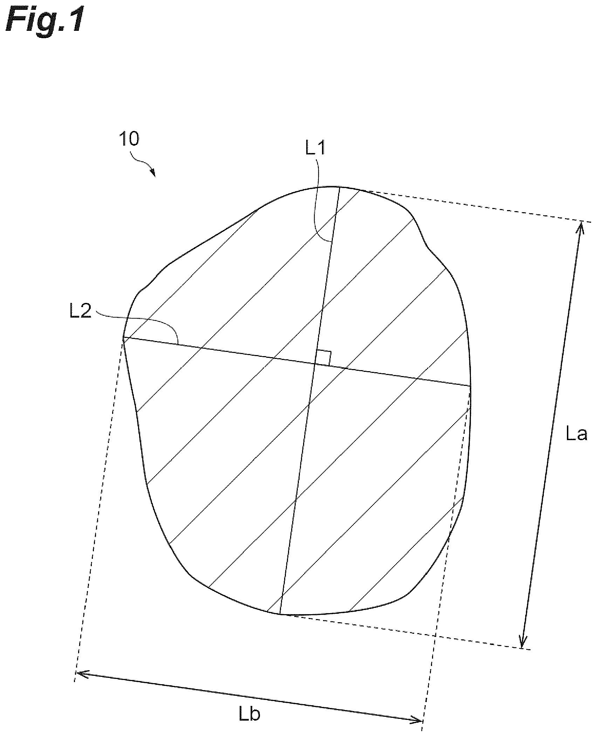

FIG. 1 is a view schematically illustrating a cross-section of a lump particle of boron nitride included in a boron nitride sintered body. Such a cross-sectional image can be observed by magnifying a cross-section of the boron nitride sintered body at 500 times using a scanning electron microscope. As illustrated in FIG. 1, a first line segment L1 and a second line segment L2 orthogonal to each other can be drawn on a lump particle 10. Both the first line segment L1 and the second line segment L2 are imaginary line segments. The first line segment L1 and the second line segment L2 are drawn by the following procedures. In the image of the lump particle 10, two points on the outer edge of the lump particle 10 are selected such that a distance between the two points is largest. A line segment connecting the two points corresponds to the first line segment L1. Furthermore, in a direction orthogonal to the first line segment L1, other two points on the outer edge are selected such that a distance between the two points is largest. A line segment connecting the two points corresponds to the second line segment L2.

The particle diameter of the lump particle in the present specification is determined by a calculation formula of (La + Lb)/2. La and Lb each represent lengths of the first line segment L1 and the second line segment L2. Accordingly, La and Lb have a relation of La > Lb. Note that, in a case where the lengths of two line segments drawn in manner of FIG. 1 are the same as each other, a relation of La = Lb is established. The measurement of La and Lb may be performed by inputting an observation image as illustrated in FIG. 1 in image analysis software (for example, "Mac-view" manufactured by Mountech Co., Ltd., or the like).

The average value of aspect ratios of the lump particles 10 may be 1 to 6, may be 1 to 5, or may be 1 to 4. Thereby, the anisotropy and drift of the flow of the resin are decreased, so that the flow-out amount of the resin from the composite body can be further increased. The adhesiveness of the composite body can therefore be further improved. The aspect ratio in the present specification is calculated by La/Lb. The average value of aspect ratios in the present specification is determined as an arithmetic mean of aspect ratios calculated by La/Lb.

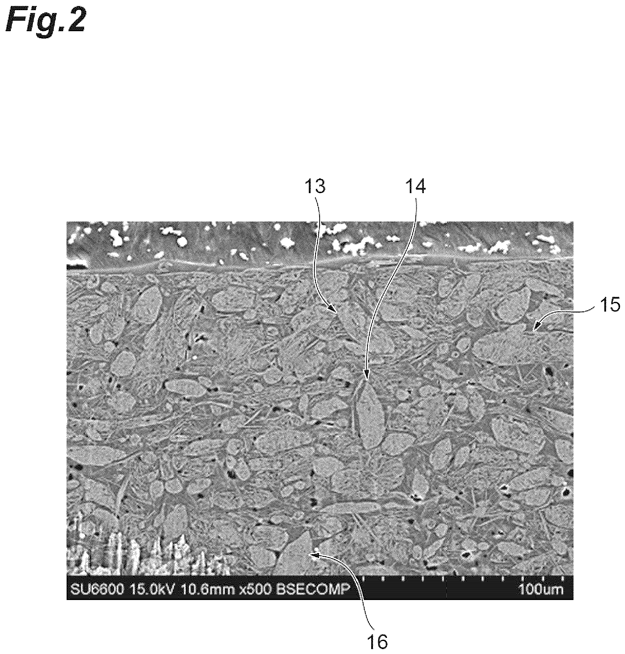

FIG. 2 is an SEM photograph showing an example of a cross-section of a boron nitride sintered body of the present embodiment. An image of the cross-section of the boron nitride sintered body shown in FIG. 2 includes lump particles of boron nitride formed by aggregation of primary particles. As shown in this image, the boron nitride sintered body has a porous structure. In the image of the cross-section of the boron nitride sintered body shown in FIG. 2, a plurality of lump particles having a particle diameter of 15 $\mu$m or more are included (for example, lump particles 13, 14, and 15).

As shown in FIG. 2, in an image obtained by magnifying a cross-section of the boron nitride sintered body observed with a scanning electron microscope (SEM) at 500 times, the average number of the lump particles having a particle diameter of 15 $\mu$m or more included in a rectangular field of view of 180 $\mu$m $\times$ 255 $\mu$m (length $\times$ width) may be

5 or more. Thereby, the flow of the resin inside the boron nitride sintered body is further smoothly performed, so that the flow-out amount of the resin from the composite body when the composite body is connected to other members can be further increased. The adhesiveness of the composite body can therefore be further improved. The average number of lump particles having a particle diameter of 15 μm or more included in the above-described field of view may be 7 or more, may be 8 or more, or may be 9 or more.

The cross-section observation with a scanning electron microscope is performed at five or more fields of view different from one another. Then, the average number of lump particles having a particle diameter of 15 μm or more observed in each field of view is determined. Thereby, a variation occurring due to the selection of the field of view can be sufficiently reduced. The average value of the number of lump particles is determined by averaging the number of lump particles measured in five or more fields of view. The number of particles in each field of view is preferably 100 or more. This is intended to exclude the fact that only a field of view not including lump particles or including a small number of lump particles is arbitrarily selected and the number of lump particles having a predetermined particle diameter or more is counted less than the actual number thereof.

Note that, even in the case of a lump particle whose only a part appears as the lump particle 16 shown in FIG. 2, when the particle diameter of the appearing part is measured and the particle diameter thereof is 15 μm or more, this lump particle is counted as a lump particle having a particle diameter of 15 μm or more. From the same viewpoint, the average number of lump particles having a particle diameter of 30 μm or more may be 5 or more, may be 8 or more, or may be 9 or more.

The lump particle of boron nitride may have a core part with primary particles of boron nitride aggregated and a shell part surrounding the core part. Thereby, when a composite body is obtained from the boron nitride sintered body, it is difficult to impede the flow of the resin near the surface of the lump particle, so that the fluidity of the resin can be further improved.

The orientation index of the boron nitride sintered body of the present embodiment may be 10 or more or may be 12 or more. Thereby, the anisotropy when the resin composition is impregnated is decreased, so that the resin can be filled inside the boron nitride sintered body with high uniformity. Thereby, the electrical insulation properties of the composite body can be further improved. The orientation index can be calculated by a peak intensity ratio $[I(002)/I(100)]$ of (002) plane to (100) plane of boron nitride as measured by an X-ray diffractometer.

The shape of the boron nitride sintered body is not particularly limited, and may be, for example, a sheet shape (thin plate shape) or may be a block shape. The boron nitride sintered body can be used in an insulating layer, a thermal interface material, and the like. The boron nitride sintered body and the lump particle included in the boron nitride sintered body contains boron nitride as a main component, and may contain accessory components other than the boron nitride. Examples of the accessory components include boron carbide, boron carbonitride, carbon, a calcium compound, and the like. The content ratio of boron nitride in the boron nitride sintered body may be 90% by mass or more, may be 95% by mass or more, or may be 98% by mass or more. The content ratio of boron nitride can be measured, for example, by X-ray diffraction measurement.

A composite body excellent in adhesiveness with other members can be formed using the boron nitride sintered body obtained in this way. Such a composite body is a composite body in which the resin is filled in the boron nitride sintered body. The composite body can be suitably used as a member of various devices such as a semiconductor device. The boron nitride sintered body having a porous structure may include both of closed pores and open pores. The porosity of the boron nitride sintered body may be 45 to 65% by volume or may be 50 to 60% by volume. The porosity can be determined based on the theoretical density and the bulk density of the boron nitride sintered body.

A composite body according to an embodiment has the above-described boron nitride sintered body and a resin filled in pores of the boron nitride sintered body. Since this composite body includes the above-described boron nitride sintered body, the flow of the resin is smoothly performed, so that the flow-out amount of the resin when the composite body is pressure-bonded to other members (adherends) can be sufficiently increased. Accordingly, adhesiveness with other members is excellent. It is not necessary to fill the resin in all of the pores of the boron nitride sintered body, and the resin may not be filled in some of the pores. The composite body may include both of closed pores and open pores.

The content of the resin in the composite body may be 20% by mass or more, may be 25% by mass or more, or may be 35% by mass or more, from the viewpoint of sufficiently increasing an adhesion force. From the viewpoint of sufficiently highly maintaining the thermal conductivity of the composite body, the content of the resin in the composite body may be 45% by mass or less or may be 40% by mass or less.

The resin may be a resin composition or may be a semi-cured product obtained by semi-curing the resin composition. The semi-curing (B-stage) means that curing can be further performed by a curing treatment thereafter. The composite body may be temporarily pressure-bonded to other members such as a metallic substrate by utilizing the resin in a semi-cured state and then heated to be attached to the other members. The semi-cured product is further subjected to the curing treatment so that the resin may be in a "fully cured" (also referred to as C-stage) state. Whether or not the resin is in a semi-cured state can be checked, for example, by a differential scanning calorimeter.

The resin may be a thermosetting resin composition and/or a photo-curable resin composition, or may be a semi-cured product thereof. The thermosetting resin composition may contain at least one compound selected from the group consisting of a compound having a cyanate group, a compound having a bismaleimide group, and a compound having an epoxy group, and a curing agent.

Examples of the compound having a cyanate group include dimethylmethylene bis(1,4-phenylene)biscyanate, bis(4-cyanatophenyl)methane, and the like. Dimethylmethylene bis(1,4-phenylene)biscyanate is commercially available, for example, as TACN (manufactured by MITSUBISHI GAS CHEMICAL COMPANY, INC., trade name).

Examples of the compound having a bismaleimide group include N,N'-[(1-methylethylidene)bis[[p-phenylene)oxy(p-phenylene)]]bismaleimide, 4,4'-diphenylmethane bismaleimide, and the like. N,N'-[(1-methylethylidene)bis[[p-phenylene)oxy(p-phenylene)]]bismaleimide is commercially available, for example, as BMI-80 (manufactured by K.I Chemical Industry Co., Ltd., trade name).

Examples of the compound having an epoxy group include a bisphenol F type epoxy resin, a bisphenol A type epoxy resin, a biphenyl type epoxy resin, a polyfunctional epoxy resin, and the like. For example, 1,6-bis(2,3-epoxypropan-1-yloxy)naphthalene or the like that is commercially available as HP-4032D (manufactured by DIC Corporation, trade name) may be exemplified.

The curing agent may include a phosphine-based curing agent and an imidazole-based curing agent. The phosphine-based curing agent may promote a triazine-generating reaction by trimerization of the compound having a cyanate group or a cyanate resin. Examples of the phosphine-based curing agent include tetraphenyl phosphonium tetra-p-tolyl borate, tetraphenyl phosphonium tetraphenyl borate, and the like. Tetraphenyl phosphonium tetra-p-tolyl borate is commercially available, for example, as TPP-MK (manufactured by HOKKO CHEMICAL INDUSTRY CO., LTD., trade name).

The imidazole-based curing agent generates oxazoline and promotes a curing reaction of the compound having an epoxy group or an epoxy resin. Examples of the imidazole-based curing agent include 1-(1-cyanomethyl)-2-ethyl-4-methyl-1H-imidazole, 2-ethyl-4-methylimidazole, and the like. 1-(1-Cyanomethyl)-2-ethyl-4-methyl-IH-imidazole is commercially available, for example, as 2E4MZ-CN (manufactured by SHIKOKU CHEMICALS CORPORATION, trade name).

The content of the phosphine-based curing agent may be, for example, 5 parts by mass or less, 4 parts by mass or less, or 3 parts by mass or less, with respect to 100 parts by mass of the total amount of the compound having a cyanate group, the compound having a bismaleimide group, and the compound having an epoxy group. The content of the phosphine-based curing agent may be, for example, 0.1 parts by mass or more or 0.5 parts by mass or more, with respect to 100 parts by mass of the total amount of the compound having a cyanate group, the compound having a bismaleimide group, and the compound having an epoxy group.

The content of the imidazole-based curing agent may be, for example, 0.1 parts by mass or less, 0.05 parts by mass or less, or 0.03 parts by mass or less, with respect to 100 parts by mass of the total amount of the compound having a cyanate group, the compound having a bismaleimide group, and the compound having an epoxy group. The content of the imidazole-based curing agent may be, for example, 0.001 parts by mass or more or 0.005 parts by mass or more, with respect to 100 parts by mass of the total amount of the compound having a cyanate group, the compound having a bismaleimide group, and the compound having an epoxy group.

The resin composition is not limited to the above-described examples, and a resin composition with which the boron nitride sintered body can be impregnated can be appropriately used.

A method for manufacturing a boron nitride sintered body according to an embodiment includes a nitriding step of firing a raw material powder containing boron carbide in an atmosphere containing nitrogen to obtain a fired product including lump particles each having a core part with primary particles of boron carbonitride aggregated and a shell part surrounding the core part, and a firing step of molding and heating a blend containing the fired product including lump particles and a sintering aid to obtain the boron nitride sintered body having a porous structure.

A powder containing boron carbide can be prepared, for example, by the following procedures. Boric acid and acetylene black are mixed and then heated in an inert gas atmosphere at 1800 to 2400°C for 1 to 10 hours to obtain a lump product containing boron carbide. The powder containing boron carbide can be prepared by subjecting this lump product to pulverization, washing, impurity removal, and drying.

In the nitriding step, a powder containing boron carbide is fired in an atmosphere containing nitrogen to obtain a fired product containing boron carbonitride ($B_4CN_4$). The firing temperature in the nitriding step may be 1800°C or higher or may be 1900°C or higher. Furthermore, this firing temperature may be 2400°C or lower or may be 2200°C or lower. This firing temperature may be, for example, 1800 to 2400°C.

The nitrogen partial pressure in the nitriding step may be 0.6 MPa or more or may be 0.7 MPa or more. The nitrogen partial pressure may be 1.0 MPa or less or may be 0.9 MPa or less. The nitrogen partial pressure may be, for example, 0.6 to 1.0 MPa. When the nitrogen partial pressure is too low, there is a tendency that the nitriding of boron carbide is difficult to proceed. When this pressure is too high, there is a tendency that manufacturing cost is increased. Note that, the pressure in the present disclosure is an absolute pressure.

The nitrogen gas concentration of the atmosphere containing nitrogen in the nitriding step may be 95% by volume or more or may be 99.9% by volume or more. The firing time in the nitriding step is not particularly limited as long as it is in a range in which the nitriding of boron carbide sufficiently proceeds, and for example, may be 6 to 30 hours or may be 8 to 20 hours.

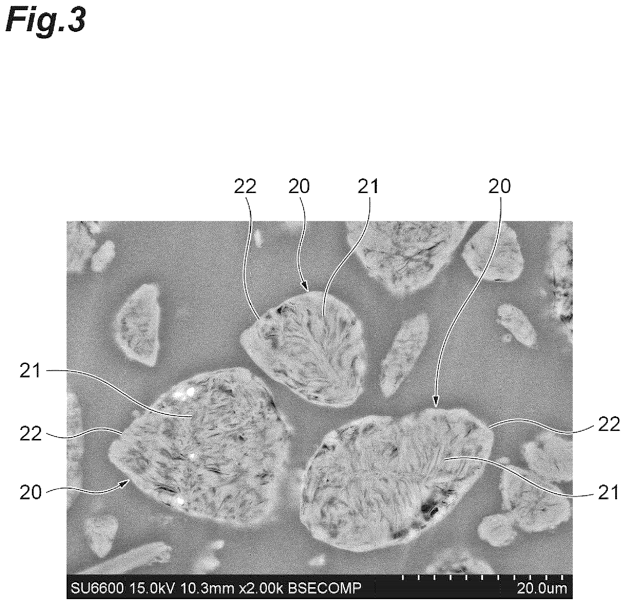

FIG. 3 is an SEM photograph of an example of lump particles of boron carbonitride obtained in a nitriding step. A lump particle 20 shown in FIG. 3 has a core part 21 with a plurality of primary particles of boron carbonitride aggregated and a shell part 22 surrounding the core part 21. The shell part 22 forms the contour of the lump particle 20 over the entire circumference of the lump particle 20. By performing the firing step while the shell part 22 of the lump particle 20 as described above is maintained, a boron nitride sintered body including lump particles can be obtained.

Another example of the lump particle may have a through-hole at the center of the core part. The fired product and a sintering aid are mixed such that the through-hole of the lump particle is maintained, thereby preparing and firing a blend. Thereby, a boron nitride sintered body including a lump particle of boron nitride having a through-hole can be obtained. The boron nitride sintered body includes such a lump particle having a through-hole, so that the circulation of the resin in the boron nitride sintered body can be further smoothly performed.

The sintering aid has a function of generating boron nitride from boron carbonitride and promoting an increase in density of boron nitride. The sintering aid may contain a boron compound having oxygen as a constituent element and a calcium compound. The content of boron carbonitride in the blend may be 70% by mass or more or may be 80% by mass or more, from the viewpoint of obtaining a boron nitride sintered body with less impurities. The blend may contain 1 to 50 parts by mass, 3 to 47 parts by mass, or 5 to 45 parts by mass of the boron compound and the calcium compound in total, with respect to 100 parts by mass of the fired product. When the content of the sintering aid in the blend is excessively large, the grain growth of primary particles of boron nitride tends to excessively proceed. On the other hand, when the content of the sintering aid in the blend is excessively small, there are tendencies that the generation of boron nitride and the grain growth are difficult to proceed and the thermal conductivity of the boron nitride sintered body is decreased.

The blend may contain 0.5 to 70 atom% or 1 to 69 atom% of calcium constituting the calcium compound with respect to 100 atom% of boron constituting the boron compound. When the blend contains boron and calcium in such a ratio, the grain growth is promoted, and the thermal conductivity of the boron nitride sintered body can be increased.

Examples of the boron compound having oxygen as a constituent element include boric acid, boron oxide, borax, diboron trioxide, and the like. Examples of the calcium compound include calcium carbonate, calcium oxide, and the like. The sintering aid may contain a component other than the boron compound and calcium carbonate. Examples of such a component include carbonates of alkali metals such as lithium carbonate and sodium carbonate. Furthermore, for moldability improvement, a binder may be blended in the blend. Examples of the binder include an acrylic compound and the like.

The fired product and the sintering aid may be blended, for example, using a mixer such as a Henschel mixer. At this time, in order to suppress breakage of the shell part of the lump particle of boron carbonitride, it may be preferable to set mixing conditions mild by mixing at a low-revolution speed for a short time, or the like. The degree of breakage of the shell part of the lump particle of boron carbonitride can be evaluated with the specific surface area of the fired product and/or the blend containing the fired product and the sintering aid. The specific surface area of the fired product and/or the blend containing the fired product and the sintering aid may be less than 12 $m^2$/g or may be less than 11.5 $m^2$/g. Thereby, the particle diameter of the lump particle of boron nitride included in the boron nitride sintered body can be sufficiently increased. The specific surface area in the present disclosure is measured by a single point BET method. The specific surface area may be 5 $m^2$/g or more, may be 7 $m^2$/g or more, or may be 9 $m^2$/g or more, from the viewpoint of promoting generation of boron nitride and an increase in density of boron nitride in the firing step. Note that, the fired product containing boron carbonitride obtained in the nitriding step may be pulverized using a pulverizer.

The blend obtained by blending the fired product and the sintering aid may be formed into a block-shaped or sheet-shaped molded body by powder pressing or die molding. Alternatively, the above-described blend may be formed into a sheet-shaped molded body by a doctor blade method. The molding pressure may be, for example, 5 to 350 MPa.

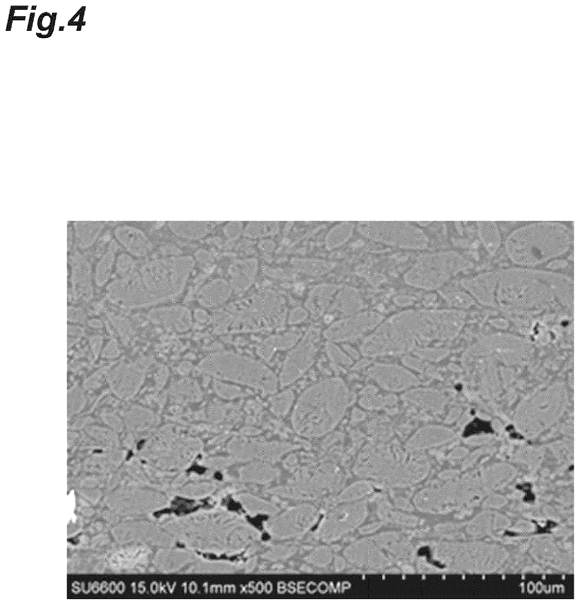

FIG. 4 is an SEM photograph showing an example of a cross-section of a molded body. As shown in FIG. 4, the molded body includes a plurality of lump particles of boron carbonitride and pores between the lump particles. Such a molded body is fired, for example, by heating in an electric furnace. The heating temperature in the firing step may be, for example, 1800°C or higher or may be 1900°C or higher. This heating temperature may be, for example, 2200°C or lower or may be 2100°C or lower. When the heating temperature is too low, there is a tendency that the grain growth does not sufficiently proceed. The heating time may be 0.5 hours or longer, may be 1 hour or longer, may be 3 hours or longer, may be 5 hours or longer, or may be 10 hours or longer. This heating time may be 40 hours or shorter, may be 30 hours or shorter, or may be 20 hours or shorter. This heating time may be, for example, 0.5 to 40 hours or may be 1 to 30 hours. When the heating time is too short, there is a tendency that the grain growth does not sufficiently proceed. When the heating time is too long, there is a tendency that manufacturing cost is increased. The heating atmosphere may be, for example, an inert gas atmosphere such as nitrogen, helium, or argon. In the case of blending a binder in the blend, degreasing may be performed by calcining at a temperature and an atmosphere where the binder is decomposed, before the above-described heating. By the above manufacturing method, a boron nitride sintered body having a porous structure and including lump particles of boron nitride can be obtained.

A method for manufacturing a composite body according to an embodiment includes an impregnating step of impregnating a boron nitride sintered body obtained by the above-described manufacturing method with a resin composition. The impregnating step is performed by attaching the resin composition to the boron nitride sintered body. For example, the boron nitride sintered body may be immersed in the resin composition. The impregnating may be performed in the state of the boron nitride sintered body being immersed under a pressurized or depressurized condition. In this way, the resin can be filled in the pores of the boron nitride sintered body. As the resin composition, the above-described thermosetting resin composition may be used. Since the boron nitride sintered body has a porous structure and includes lump particles having a particle diameter equal to or more than a predetermined value, impregnation with the resin composition can also be smoothly performed. Thus, the content of the resin can also be sufficiently increased.

The impregnating step may be performed using the inside of an impregnating apparatus including an airtight container. As an example, the impregnating may be performed inside the impregnating apparatus under a depressurized condition, and then the impregnating may be performed under a pressurized condition by increasing the pressure inside the impregnating apparatus to be higher than the atmospheric pressure. By performing both the depressurized condition and the pressurized condition in this way, the resin can be sufficiently filled in the pores of the boron nitride sintered body. The depressurized condition and the pressurized condition may be repeated multiple times. The impregnating step may be performed while heating. In the resin composition impregnated in the pores of the boron nitride sintered body, the solvent may volatilize or curing or semi-curing may proceed. In this way, a composite body having the boron nitride sintered body and a resin filled in the pores thereof is obtained.

The method may include a semi-curing step of semi-curing the resin filled in the pores after the impregnating step. In the semi-curing step, for example, the composite body filled with the resin is extracted from the impregnating apparatus, and then the resin composition is semi-cured by heating and/or light irradiation depending on the type of the resin composition (or a curing agent to be added as necessary).

The composite body obtained in this way has a sheet shape and a thin thickness. Thus, the composite body is thin and lightweight, and when the composite body is used as a member of an electronic component and the like, a decrease in size and weight of an electronic component and the like can be achieved. Furthermore, since the resin is sufficiently filled in the pores of the boron nitride sintered body, the composite body is also excellent in insulation properties. However, the use application thereof is not limited to a heat dissipation member.

Hereinbefore, several embodiments have been described, but the present disclosure is not intended to be limited to the above-described embodiments at all. For example, in the firing step, a boron nitride sintered body may be obtained using a hot press in which molding and firing are simultaneously performed.

## Examples

The contents of the present disclosure will be more specifically described with reference to Examples and Comparative Examples; however, the present disclosure is not limited to the following Examples.

[Boron nitride sintered body]

(Example 1)

<Preparation of boron carbonitride powder>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible and heated using an arc furnace in an argon gas atmosphere at 2200°C for 5 hours to obtain lump boron carbide ($B_4C$). The obtained lump product was coarsely pulverized with a jaw crusher to obtain a coarse powder of boron carbide ($B_4C$). This coarse powder was further pulverized with a ball mill having silicon carbide balls ($\phi$10 mm) to obtain a pulverized powder. The carbon amount of the obtained boron carbide powder was 19.9% by mass. The carbon amount was measured with a carbon/sulfur simultaneous analyzer.

The prepared boron carbide powder was filled in a boron nitride crucible. Thereafter, the crucible was heated for 10 hours using a resistance heating furnace in a nitrogen gas atmosphere under the conditions of 2000°C and 0.85 MPa. In this way, a fired product containing boron carbonitride ($B_4CN_4$) was obtained.

<Measurement of specific surface area>

The specific surface area of the fired product containing boron carbonitride was measured using a specific surface area measuring device (trade name: Macsorb HM Model-1200) manufactured by Mountech Co., Ltd. by a single point BET method. Measurement results were as shown in Table 1.

<Measurement of content of boron carbonitride>

The content of the boron carbonitride of the fired product containing boron carbonitride was determined by Calculation Formula (1) below from an actual measurement value D [% by mass] of the nitrogen content and the theoretical nitrogen content (50.4% by mass) in the boron carbonitride.

$$\text{Content (\% by mass) of boron carbonitride} = D/50.4 \times 100 \quad (1)$$

The actual measurement value D of the nitrogen content was measured using an oxygen/nitrogen analyzer (trade name: EMGA-920) manufactured by HORIBA, Ltd. The content of the boron carbonitride by Calculation Formula (1) was 98% by mass.

<Observation with scanning electron microscope (SEM)>

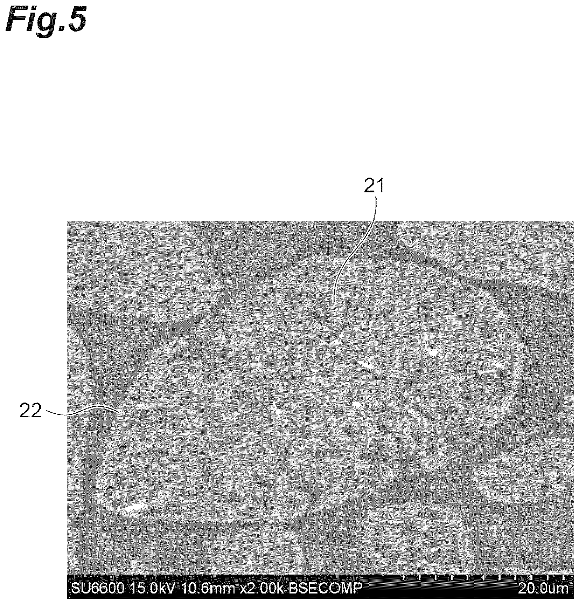

The fired product containing boron carbonitride ($B_4CN_4$) was cut using an ion milling device to obtain a cross-section. The cross-section of the fired product was magnified at 500 times and observed using a scanning electron microscope (manufactured by Hitachi High-Tech Corporation, device name: SU6600). FIG. 5 is an SEM photograph of a cross-section of a lump particle included in a fired product. As shown in FIG. 5, it was confirmed that the lump particle included in the fired product has the core part 21 with a plurality of primary particles of boron carbonitride aggregated and the shell part 22 surrounding the core part 21. In twenty fields of view different from one another, each image as shown in FIG. 5 was captured, and each lump particle included in each SEM photograph was observed. As a result, it was confirmed that all the lump particles each have a core part with a plurality of primary particles of boron carbonitride aggregated and a shell part surrounding the core part.

<Production of boron nitride sintered body>

Powdery boric acid and calcium carbonate were blended to prepare a sintering aid. Upon the preparation, 1.9 parts by mass of calcium carbonate was blended with respect to 100 parts by mass of boric acid. Regarding the atomic ratio of boron and calcium at this time, the atomic ratio of calcium was 1.2 atom% with respect to 100 atom% of boron. 19 parts by mass of the sintering aid was blended with respect to 100 parts by mass of the fired product including lump particles of boron carbonitride described above and mixed using a Henschel mixer at 740 rpm for 3 minutes to obtain a blend. The specific surface area of the obtained blend was measured in the same manner as in the measurement of the specific surface area of the fired product. Results were as shown in Table 1.
The blend was pressurized using a powder pressing machine at 150 MPa for 30 seconds to obtain a molded body having a quadrilateral prism shape (length × width × thickness = 50 mm × 50 mm × 50 mm). The molded body was put in a boron nitride container and introduced into a batch-type high-frequency furnace. In the batch-type high-frequency furnace, heating was performed for 5 hours under the conditions of normal pressure, a nitrogen flow rate of 5 L/min, and 2000°C. Thereafter, a boron nitride sintered body was extracted from the boron nitride container. In this way, a quadrilateral prism shape boron nitride sintered body was obtained. The thickness of the boron nitride sintered body was 53 mm.

<Measurement of porosity>

The porosity was determined by Calculation Formula (2) below from a bulk density B and the theoretical density (2280 kg/m$^3$) of boron nitride. The porosity was as shown in Table 1.

$$\text{Porosity (\% by volume)} = [1 - (B/2280)] \times 100 \quad (2)$$

<Measurement of orientation index>

The orientation index [I(002)/I(100)] of the boron nitride sintered body was determined using an X-ray diffractometer (manufactured by Rigaku Corporation, trade name: ULTIMA-IV). A measurement sample (boron nitride sintered body) set on a sample holder of the X-ray diffractometer was irradiated with X rays to perform baseline correction. Thereafter, the peak intensity ratio of (002) plane to (100) plane of boron nitride was calculated. This peak intensity ratio was regarded as the orientation index [I(002)/I(100)]. Results were as shown in Table 1.

<Cross-section observation with scanning electron microscope (SEM)>

The boron nitride sintered body was cut along a thickness direction using a CP polishing machine to obtain a cross-section. This cross-section was magnified at 500 times and observed with a scanning electron microscope (manufactured by Hitachi High-Tech Corporation, device name: SU6600). FIG. 2 is an SEM photograph showing a cross-section of a boron nitride sintered body of Example 1. When the cross-section of the boron nitride sintered body as shown in FIG. 2 was observed in five fields of view (length $\times$ width = 180 $\mu$m $\times$ 255 $\mu$m) different from one another, it was confirmed that the boron nitride sintered body includes five or more lump particles having a particle diameter of 15 $\mu$m or more on average. The average value of aspect ratios of the lump particles having a particle diameter of 15 $\mu$m or more was 2. In the section "SEM observation" in Table 1, the number (average value) of lump particles having a particle diameter of 15 $\mu$m or more included in a rectangular field of view of 180 $\mu$m $\times$ 255 $\mu$m was shown.

(Example 2)

Powdery boric acid and calcium carbonate were blended to prepare a sintering aid. Upon the preparation, 95.6 parts by mass of calcium carbonate was blended with respect to 100 parts by mass of boric acid. 44.3 parts by mass of this sintering aid was blended with respect to 100 parts by mass of the fired product including lump particles of boron carbonitride prepared by the same procedure as in Example 1 and mixed using a Henschel mixer at 740 rpm for 3 minutes to obtain a blend. A boron nitride sintered body was manufactured in the same manner as in Example 1, except that this blend was used. The measurement of the specific surface areas of the fired product and the blend, and each measurement and the SEM observation of the boron nitride sintered body were performed in the same manner as in Example 1.
When the cross-section of the boron nitride sintered body as shown in FIG. 2 was observed in five fields of view (length $\times$ width = 180 $\mu$m $\times$ 255 $\mu$m) different from one another, it was confirmed that five or more lump particles having a particle diameter of 15 $\mu$m or more are included. The average value of aspect ratios of the lump particles having a particle diameter of 15 $\mu$m or more was 2. The other measurement results were as shown in Table 1.

(Example 3)

The fired product containing boron carbonitride ($B_4CN_4$) obtained in Example 1 was pulverized using a ball mill for 2 hours to be powdered. When the SEM observation of the powdery fired product was performed in the same manner as in Example 1, it was confirmed that the fired product includes lump particles each having the core part 21 with a plurality of primary particles of boron carbonitride aggregated and the shell part 22 surrounding the core part 21. The specific surface area of this powdery fired product was measured in the same manner as in Example 1. Measurement results were as shown in the section of "Fired product" of Table 1. This fired product and a sintering aid were mixed using a Henschel mixer at 740 rpm for 3 minutes to prepare a blend. A boron nitride sintered body was manufactured using this blend in the same manner as in Example 1. The measurement of the specific surface area of the blend, and each measurement and the SEM observation of the boron nitride sintered body were performed in the same manner as in Example 1.
When the cross-section of the boron nitride sintered body as shown in FIG. 2 was observed in five fields of view (length $\times$ width = 180 $\mu$m $\times$ 255 $\mu$m) different from one another, it was confirmed that the boron nitride sintered body includes five or more lump particles having a particle diameter of 15 $\mu$m or more on average. The average value of aspect ratios of the lump particles having a particle diameter of 15 $\mu$m or more was 2. The other measurement results were as shown in Table 1.

(Comparative Example 1)

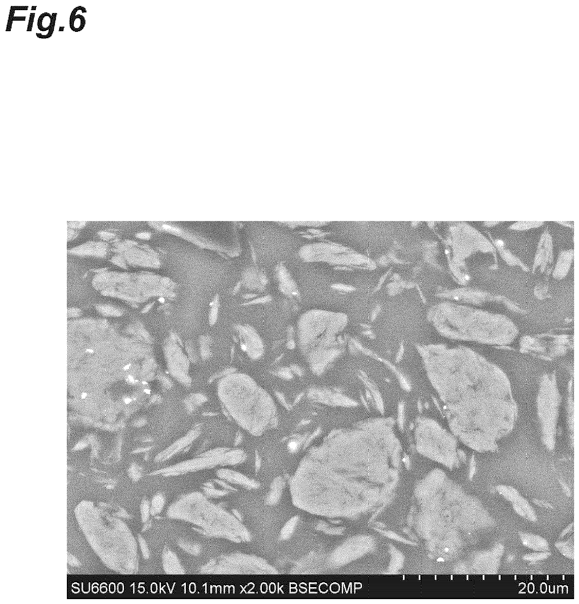

A fired product containing boron carbonitride ($B_4CN_4$) was prepared by the same procedure as in Example 1. When the specific surface area of the fired product was measured in the same manner as in Example 1, measurement results were as shown in Table 1. This fired product was pulverized using a ball mill for 16 hours to be powdered. The SEM photograph of the boron carbonitride powder obtained by pulverizing the fired product was as shown in FIG. 6. As shown in FIG. 6, it was confirmed that, in the boron carbonitride powder obtained by pulverizing the fired product, the shell part disappears in all the lump particles, and the primary particle is exposed on the outer edge of the lump particle.

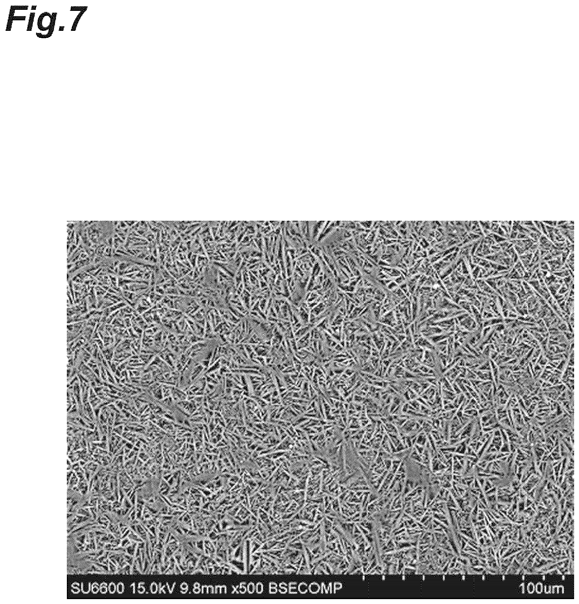

The boron carbonitride powder obtained in this way and a sintering aid were mixed using a Henschel mixer to prepare a blend. A boron nitride sintered body was manufactured using this blend in the same manner as in Example 1. The measurement of the specific surface area of the blend, and each measurement and the SEM observation of the boron nitride sintered body were performed in the same manner as in Example 1. Results of each measurement were as shown in Table 1. The SEM photograph of the cross-section of the boron nitride sintered body was as shown in FIG. 7. When the cross-section of the boron nitride sintered body as shown in FIG. 7 was observed in five fields of view (length × width = 180 μm × 255 μm) different from one another, the boron nitride sintered body of Comparative Example 1 did not include even one lump particle having a particle diameter of 15 μm or more.

[Table 1]

| | Fired product | Blend | Boron nitride sintered body | | |
|---|---|---|---|---|---|
| | Specific surface area [m$^2$/g] | Specific surface area [m$^2$/g] | Porosity [% by volume] | Orientation index | SEM observation [number] |
| Example 1 | 11.5 | 11.5 | 57.3 | 14 | ≥ 5 |
| Example 2 | 11.5 | 11.5 | 59.2 | 12 | ≥ 5 |
| Example 3 | 11.8 | 11.8 | 54.8 | 12 | ≥ 5 |
| Comparative Example 1 | 11.5 | 12.7 | 57.3 | 14 | 0 |

[Composite body]

<Production of composite body>

In an impregnating apparatus in which the pressure was controlled to 0.03 kPa, each of the boron nitride sintered bodies of Examples 1 to 3 and Comparative Example 1 was immersed in a resin composition containing an epoxy resin (manufactured by Mitsubishi Chemical Corporation, trade name: Epikote 807) and a curing agent (manufactured by Nippon Synthetic Chemical Industry Co., Ltd., trade name: Akumex H-84B) to impregnate the boron nitride sintered body with the resin composition. After the impregnating, the resin composition was semi-cured by heating at the atmospheric pressure and at a temperature of 150°C for 60 minutes to obtain a composite body. This composite body had the thickness that was equal to that of the boron nitride sintered body.

<Measurement of content of resin>

The content of the resin was determined by firing the composite body in air at 600°C for 5 hours and calculating the content of the resin from a change in mass before and after the firing by Formula (3) below. Results were as shown in Table 2.

$$\text{Content (\% by mass) of resin in composite body} = (\text{Mass of composite body before firing - Mass of composite body after firing})/\text{Mass of composite body before firing} \times 100 \cdots (3)$$

<Evaluation of adhesion strength>

The composite body was processed into a predetermined size (length × width × thickness = 40 mm × 20 mm × 0.4 mm) using a multi-cut wire saw to obtain a sheet-shaped sample. The above-described sheet-shaped sample was disposed between a sheet-shaped copper foil (length × width × thickness = 100 mm × 20 mm × 0.035 mm) and a flat copper plate (length × width × thickness = 100 mm × 20 mm × 1 mm) to obtain a laminate including the copper foil, the composite body, and the copper plate in this order. This laminate was pressure-bonded by heating and pressurizing for 5 minutes under the conditions of 200°C and 5 MPa, and then subjected to a heating treatment for 2 hours under the conditions of 200°C and atmospheric pressure.

After the above-described treatment was performed, a 90° peel test was performed according to "Adhesives-Determination of peel strength of bonded assemblies" of JIS K 6854-1:1999, and the peel strength of the composite body at 20°C was determined using a universal tester (manufactured by A&D Company, Limited, trade name: RTG-1310). Measurement was performed under the conditions of a test speed of 50 mm/min, a load cell of 5 kN, and a measurement temperature of room temperature (20°C). Results were as shown in the section "Adhesion strength evaluation" in Table 2. Note that, a cohesive failure portion refers to an area of a portion at which the composite body is broken.

A: The area proportion of the cohesive failure portion is 70 area% or more.
B: The area proportion of the cohesive failure portion is less than 70 area%.

[Table 2]

|  | Resin content [% bv mass] | Adhesion strength evaluation |
|---|---|---|
| Example 1 | 40.0 | A |
| Example 2 | 42.8 | A |
| Example 3 | 37.5 | A |
| Comparative Example 1 | 34.5 | B |

**Industrial Applicability**

According to the present disclosure, there are provided a boron nitride sintered body with which a composite body excellent in adhesiveness with other members can be formed and a method for manufacturing the same. Furthermore, there are provided a composite body excellent in adhesiveness with other members and a method for manufacturing the same.

**Reference Signs List**

10, 13, 14, 15, 16, 20: lump particle, 21: core part, 22: shell part.

**Claims**

1. A boron nitride sintered body having a porous structure, the boron nitride sintered body comprising:
a lump particle formed by aggregation of primary particles of boron nitride and having a particle diameter of 15 $\mu$m or more.

2. The boron nitride sintered body according to claim 1, wherein, in an image obtained by magnifying a cross-section of the boron nitride sintered body observed with a scanning electron microscope at 500 times, an average number of the lump particles having the particle diameter of 15 $\mu$m or more included in a rectangular field of view of 180 $\mu$m × 255 $\mu$m is 5 or more.

3. The boron nitride sintered body according to claim 1 or 2, wherein an average value of aspect ratios of the lump particles is 1 to 6.

4. The boron nitride sintered body according to any one of claims 1 to 3, wherein the lump particle has a core part with primary particles of boron nitride aggregated, and a shell part surrounding the core part.

5. The boron nitride sintered body according to any one of claims 1 to 3, wherein an orientation index is 10 or more.

6. The boron nitride sintered body according to any one of claims 1 to 5, wherein the boron nitride sintered body includes a plurality of the lump particles, and at least one of the plurality of lump particles has a through-hole.

7. A method for manufacturing a boron nitride sintered body, the method comprising:

a nitriding step of firing a raw material powder containing boron carbide in an atmosphere containing nitrogen to obtain a fired product including lump particles each having a core part with primary particles of boron carbonitride aggregated and a shell part surrounding the core part; and

a firing step of molding and heating a blend containing the fired product including lump particles and a sintering aid to obtain a boron nitride sintered body having a porous structure and including lump particles of boron nitride.

8. The method for manufacturing the boron nitride sintered body according to claim 7, wherein the lump particle is formed by aggregation of primary particles of boron nitride and has a particle diameter of 15 μm or more.

9. The method for manufacturing the boron nitride sintered body according to claim 7 or 8, wherein a specific surface area of at least one of the fired product and the blend is less than 12 m²/g.

10. A composite body comprising:

the boron nitride sintered body according to any one of claims 1 to 6; and
a resin filled in pores of the boron nitride sintered body.

11. A method for manufacturing a composite body, the method comprising an impregnating step of impregnating pores of the boron nitride sintered body obtained by the manufacturing method according to any one of claims 7 to 9 with a resin composition, the composite body having the boron nitride sintered body and a resin filled in at least some of the pores of the boron nitride sintered body.

12. The method for manufacturing the composite body according to claim 11, comprising a semi-curing step of semi-curing the resin composition impregnated in the pores.

*Fig.1*

# Fig.2

# Fig.3

# Fig.4

# *Fig.5*

Fig.6

SU6600 15.0kV 10.1mm x2.00k BSECOMP                    20.0um

*Fig.7*

SU6600 15.0kV 9.8mm x500 BSECOMP 100um

<table>
<tr><td colspan="2" align="center">**INTERNATIONAL SEARCH REPORT**</td><td>International application No.<br>PCT/JP2021/013054</td></tr>
</table>

**A. CLASSIFICATION OF SUBJECT MATTER**
Int. Cl. C01B21/064(2006.01)i, H01L23/373(2006.01)i, C04B38/00(2006.01)i, C04B41/83(2006.01)i, C04B35/583(2006.01)i, H05K7/20(2006.01)i
FI: C04B35/583, C01B21/064 G, C04B38/00 303Z, C04B38/00 304Z, C04B41/83 G, H01L23/36 M, H05K7/20 F

According to International Patent Classification (IPC) or to both national classification and IPC

**B. FIELDS SEARCHED**

Minimum documentation searched (classification system followed by classification symbols)
Int. Cl. C01B21/064, H01L23/373, C04B38/00, C04B41/83, C04B35/583, H05K7/20

Documentation searched other than minimum documentation to the extent that such documents are included in the fields searched
Published examined utility model applications of Japan      1922-1996
Published unexamined utility model applications of Japan    1971-2021
Registered utility model specifications of Japan            1996-2021
Published registered utility model applications of Japan    1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-162697 A (DENKI KAGAKU KOGYO KABUSHIKI KAISHA) 08 September 2014, claims, examples 1-27 | 1-3, 5, 10 |
| X | WO 2014/136959 A1 (DENKI KAGAKU KOGYO KABUSHIKI KAISHA) 12 September 2014, claims, examples 1-14 | 1-3, 5, 10 |
| X | WO 2011/104996 A1 (MITSUBISHI ELECTRIC CORP.) 01 September 2011, claims, paragraph [0015], examples 1-6 | 1-3, 6, 10 |
| X | JP 2017-165609 A (DENKA CO., LTD.) 21 September 2017, claims, examples 1-10 | 1-3, 10 |
| X | JP 2010-157563 A (MITSUBISHI ELECTRIC CORP.) 15 July 2010, claims, examples 1-8 | 1-3, 10 |

☒ Further documents are listed in the continuation of Box C.     ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>18.05.2021 | Date of mailing of the international search report<br>25.05.2021 |
|---|---|
| Name and mailing address of the ISA/<br>　　Japan Patent Office<br>　　3-4-3, Kasumigaseki, Chiyoda-ku,<br>　　Tokyo 100-8915, Japan | Authorized officer<br><br><br>Telephone No. |

Form PCT/ISA/210 (second sheet) (January 2015)

**INTERNATIONAL SEARCH REPORT**

| | International application No. |
|---|---|
| | PCT/JP2021/013054 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2016-044098 A (SUMITOMO BAKELITE CO., LTD.) 04 April 2016, entire text | 1-12 |

Form PCT/ISA/210 (continuation of second sheet) (January 2015)

INTERNATIONAL SEARCH REPORT
Information on patent family members

| International application No. |
|---|
| PCT/JP2021/013054 |

| Patent Documents referred to in the Report | Publication Date | Patent Family | Publication Date |
|---|---|---|---|
| JP 2014-162697 A | 08.09.2014 | (Family: none) | |
| WO 2014/136959 A1 | 12.09.2014 | US 2016/0060112 A1 claims EP 2966036 A1 claims CN 105026312 A claims | |
| WO 2011/104996 A1 | 01.09.2011 | JP 2011-176024 A claims US 2013/0012621 A1 claims DE 112010005303 B claims CN 102770956 A claims | |
| JP 2017-165609 A | 21.09.2017 | (Family: none) | |
| JP 2010-157563 A | 15.07.2010 | (Family: none) | |
| JP 2016-044098 A | 04.04.2016 | (Family: none) | |

Form PCT/ISA/210 (patent family annex) (January 2015)

**EP 4 101 812 A1**

**Patent documents cited in the description**

- JP 2014162697 A